(19) Europäisches Patentamt

European Patent Office

Office européen des brevets

(11) **EP 1 467 480 B1**

(12) **EUROPEAN PATENT SPECIFICATION**

(45) Date of publication and mention
of the grant of the patent:
**04.10.2006 Bulletin 2006/40**

(51) Int Cl.:
*H03D 7/00* *(2006.01)*    *H03D 7/14* *(2006.01)*

(21) Application number: **04003902.6**

(22) Date of filing: **20.02.2004**

(54) **Television tuner**

Fernsehtuner

Circuit d'accord de télévision

(84) Designated Contracting States:
**DE FR GB**

(30) Priority: **27.02.2003  JP 2003000960 U**

(43) Date of publication of application:
**13.10.2004 Bulletin 2004/42**

(73) Proprietor: **ALPS ELECTRIC CO., LTD.
Tokyo 145-8501 (JP)**

(72) Inventor: **Yamamoto, Masaki
Ota-ku
Tokyo (JP)**

(74) Representative: **Hirsch, Peter
Klunker Schmitt-Nilson Hirsch
Winzererstrasse 106
80797 München (DE)**

(56) References cited:
- PIAZZA F ET AL: "A 170 MHZ RF FRONT-END FOR ERMES PAGER APPLICATIONS" IEEE JOURNAL OF SOLID-STATE CIRCUITS, IEEE INC. NEW YORK, US, vol. 30, no. 12, 1 December 1995 (1995-12-01), pages 1430-1437, XP000557248 ISSN: 0018-9200
- WANG D ET AL INSTITUTE OF ELECTRICAL AND ELECTRONICS ENGINEERS: "A 2.5 GHz low noise high linearity LNA/mixer IC in SiGe BiCMOS technology" 2001 IEEE RADIO FREQUENCY INTEGRATED CIRCUITS (RFIC) SYMPOSIUM. DIGEST OF PAPERS. PHOENIX, AZ, MAY 20 - 22, 2001, IEEE RADIO FREQUENCY INTEGRATED CIRCUITS SYMPOSIUM, NEW YORK, NY : IEEE, US, 20 May 2001 (2001-05-20), pages 249-252, XP010551364 ISBN: 0-7803-6601-8
- YUN Y ET AL: "A HIGH PERFORMANCE DOWNCONVERTER MMIC FOR DBS APPLICATIONS" IEICE TRANSACTIONS ON ELECTRONICS, INSTITUTE OF ELECTRONICS INFORMATION AND COMM. ENG. TOKYO, JP, vol. E84-C, no. 11, November 2001 (2001-11), pages 1679-1688, XP001110779 ISSN: 0916-8524

**Description**

BACKGROUND OF THE INVENTION

1. Field of the Invention

The present invention relates to a television tuner according to the preamble of claim 1.

2. Description of the Related Art

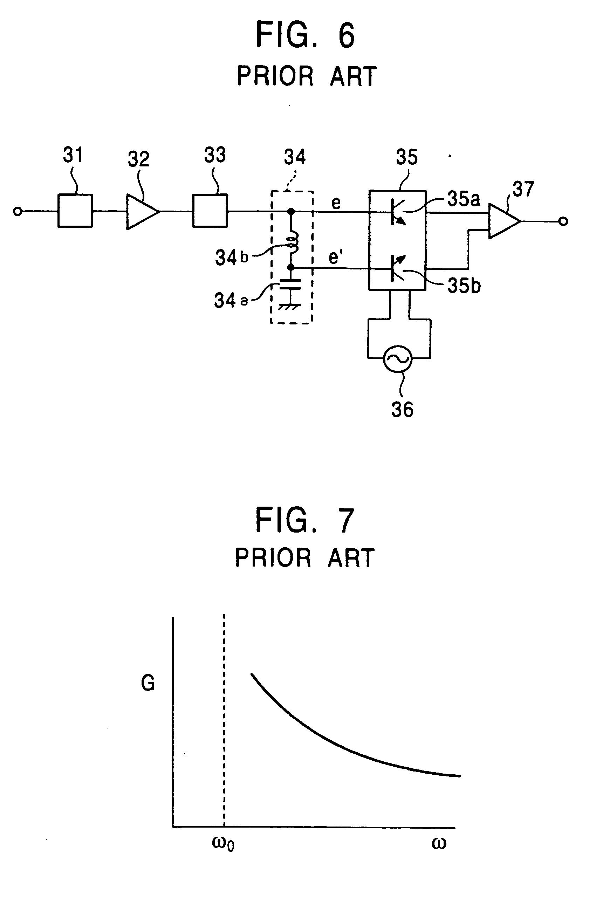

Fig. 6 shows the configuration of a conventional television tuner of the above type. Referring to Fig. 6, an input tuning circuit 31 can be tuned to, for example, a television signal in a desired channel among the channels of the UHF band. The tuned television signal is amplified by a radio-frequency amplifier 32. The amplified signal is further selected by an interstage tuning circuit 33. The interstage tuning circuit 33 thus outputs an unbalanced signal, which is input to a balun circuit 34.

The balun circuit 34 is implemented by a series resonance circuit including a capacitor 34a and an inductor 34b. One end of the capacitor 34a is grounded. The inductor 34b is connected in series with the capacitor 34a, and one end of the inductor 34b receives input of an unbalanced television signal e. The series resonance circuit is arranged such that the resonant frequency thereof is not higher than a lowest frequency of television signals.

Thus, a television signal e' that appears at a node between the capacitor 34a and the inductor 34b has an opposite phase with respect to the television signal e that is input to the inductor 34b. Accordingly, balanced television signals (e, e') are output from the balun circuit 34.

The balanced television signals are input to two transistors 35a and 35b of a mixer circuit 35, the transistors 35a and 35b being differentially connected to each other. The mixer circuit 35 is of the type generally referred to as Gilbert mixer circuit. The television signals input to the mixer circuit 35 are mixed with local oscillation signals supplied from an oscillator 36, and are thereby converted into intermediate-frequency signals. The balanced intermediate-frequency signals output from the mixer circuit 35 are input to an intermediate-frequency amplifier 37 via a balanced intermediate-frequency tuning circuit (not shown), where the signals are amplified.

Now, the phase of the television signal e' that appears at the node between the capacitor 34a and the inductor 34b in the balun circuit 34 will be described. Let a television signal output from the interstage tuning circuit 33 and input to one end of the inductor 34b be denoted as e, the capacitance of the capacitor 34a as C, and the inductance of the inductor 34b as L. Then, the television signal e' that appears at the node between the capacitor 34a and the inductor 34b is expressed by equation (1):

$$e' = \frac{-e}{\omega^2 LC - 1} \qquad\qquad (1)$$

In equation (1), if ($\omega^2 LC - 1$) is greater than zero, the television signal e' that appears at the node between the capacitor 34a and the inductor 34b has an opposite phase with respect to the input television signal e. That is, unbalanced-to-balanced conversion takes place when the frequency of the input television signal e is higher than or equal to the resonant frequency of the capacitor 34a and the inductor 34b.

As will be readily understood from equation (1), even if the television signal e that is input to the balun circuit 34 is constant, as the frequency of the television signal e becomes lower and approaches the resonant frequency of the balun circuit 34, the television signal e' that appears at the node between the capacitor 34a and the inductor 34b becomes larger. Thus, the level of the intermediate-frequency signal output from the mixer circuit 35 becomes higher as the frequency of the television signal e becomes lower. Accordingly, the gain of the tuner becomes larger at lower frequencies, as shown in Fig. 7. This causes variation in gain over the entire band.

SUMMARY OF THE INVENTION

Accordingly, it is an object of the present invention to reduce variation in gain caused by a balun circuit and to thereby achieve a flat gain over an entire reception band.

In order to achieve the above object, the present invention provides a television tuner including the features of claim 1. Preferred embodiments are defined by the dependent claims. Accordingly, increase in gain at lower frequencies of a reception band is suppressed, serving to achieve a flat gain.

Preferably, the mixer circuit is implemented by an integrated circuit and the resisting device is formed within the integrated circuit. Accordingly, increase in cost due to addition of the resisting device is avoided.

More preferably, a radio-frequency amplifier for amplifying the television signal is provided before the tuning circuit, and the resisting device is activated when power is supplied to the radio-frequency amplifier to allow operation of the radio-frequency amplifier. Accordingly, when a television signal is received, balanced television signals are input to the mixer circuit.

The resisting device may be implemented by a switching transistor, one of the collector and the emitter of the switching transistor being connected to the second input terminal of the mixer circuit and the other of the collector and the emitter being DC-connected to a power-supply terminal of the radio-frequency amplifier, with a power-supply voltage applied to one of the collector and the emitter of the switching transistor to turn the switching transistor on or off. Accordingly, power is supplied to the radio-frequency amplifier via the switching transistor that has been turned on, and the ON resistance (saturated resistance) of the switching transistor acts as a resistive component, allowing balanced television signals to be input to the mixer circuit.

Preferably, the integrated circuit has a first terminal coupled to the first input terminal of the mixer circuit and a second terminal coupled to the second input terminal of the mixer circuit, the one end of the inductor is connected to the first terminal and the node between the inductor and the capacitor is connected to the second terminal, and the power-supply terminal of the radio-frequency amplifier is DC-connected to the second terminal. Accordingly, power supply to the radio-frequency amplifier is simplified.

BRIEF DESCRIPTION OF THE DRAWINGS

Fig. 1 is a circuit diagram showing the basic configuration of a television tuner according to the present invention;
Fig. 2 is a specific circuit diagram of a television tuner according to a first embodiment of the present invention;
Fig. 3 is an equivalent circuit diagram of the television tuner according to the first embodiment of the present invention;
Fig. 4 is a graph showing characteristics regarding voltage input to a mixer circuit in the television tuner according to the present invention;
Fig. 5 is a specific circuit diagram of a television tuner according to a second embodiment of the present invention;
Fig. 6 is a circuit diagram showing the configuration of a conventional television tuner; and
Fig. 7 is a graph showing the gain characteristics of the conventional television tuner.

DESCRIPTION OF THE PREFERRED EMBODIMENTS

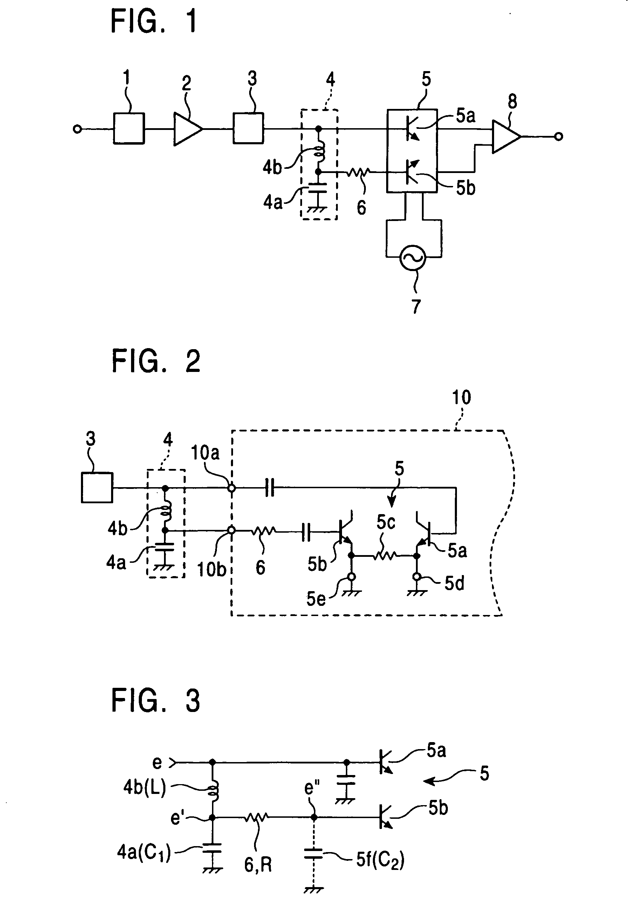

Television tuners according to the present invention will be described with reference to Figs. 1 to 4. Fig. 1 shows the basic configuration of a television tuner according to the present invention. Referring to Fig. 1, an input tuning circuit 1 can be tuned to, for example, a television signal in a desired channel among the channels of the UHF band. The tuned television signal is amplified by a radio-frequency amplifier 2. The amplified signal is further selected by an interstage tuning circuit 3. The interstage tuning circuit 3 thus outputs an unbalanced television signal, which is input to a balun circuit 4.

The balun circuit 4 is implemented by a series resonance circuit including a capacitor 4a and an inductor 4b. One end of the capacitor 4a is grounded. The inductor 4b is connected in series with the capacitor 4a, and one end of the inductor 4b receives input of an unbalanced television signal e. The series resonance circuit is arranged such that the resonant frequency thereof is not higher than a lowest frequency of television signals.

Thus, a television signal e' that appears at a node between the capacitor 4a and the inductor 4b has an opposite phase with respect to the television signal e that is input to the inductor 4b. Accordingly, balanced television signals (e and e') are output from the balun circuit 4.

The balanced television signals are input to a balanced mixer circuit 5 of the type generally referred to as Gilbert mixer. The mixer circuit 5 includes transistors 5a and 5b that are differentially connected to each other. One of the television signals, namely, the television signal e output from the interstage tuning circuit 3, is input directly to one 5a of the two transistors 5a and 5b. The other television signal, namely, the television signal e' that appears at the node between the capacitor 4a and the inductor 4b, is input to the other transistor 5b via a resisting device 6, for example, a resistor. The television signals input to the mixer circuit 5 are mixed with balanced local oscillation signals that are supplied from an oscillator 7, and are thereby converted into intermediate-frequency signals. The balanced intermediate-frequency signals output from the mixer circuit 5 are input to an intermediate-frequency amplifier 8 via a balanced intermediate-frequency tuning circuit (not shown), where the signals are amplified.

Fig. 2 shows a specific configuration according to a first embodiment of the present invention. Referring to Fig. 2, the mixer circuit 5 is included in an integrated circuit 10 having a first terminal 10a and a second terminal 10b. The two transistors 5a and 5b are differentially connected to each other by a coupling resistor 5c connected between the emitters the transistors 5a and 5b and by constant current sources 5d and 5e connected to the respective emitters of the transistors 5a and 5b. Although not shown, transistors that are differentially connected to each other are connected to the respective collectors of the transistors 5a and 5b, and local oscillation signals are supplied to the respective bases of the transistors from the oscillator 7.

The base of the transistor 5a, which serves as an input terminal, is coupled to the first terminal 10a. The resisting device 6 is coupled between the base of the transistor 5b, which serves as another input terminal, and the second terminal 10b. Obviously, the resisting device 6 is formed within the integrated circuit 10. The balun circuit 4 is provided externally to the integrated circuit 10. The inductor 4b is connected between the first terminal 10a and the second terminal 10b. The capacitor 4a is connected between the second terminal 10b and the ground.

Now, the characteristics of a television signal input to the mixer circuit 5 will be described based on an equivalent circuit shown in Fig. 3, including the balun circuit 4 and the mixer circuit 5. Referring to Fig. 3, let a television signal output from the interstage tuning circuit 3 be denoted as e, the capacitance of the capacitor 4a in the balun circuit 4 as $C_1$, the inductance of the inductor 4b as L, and the resistance of the resisting device 6 as R, the value of internal capacitance 5f of the transistor 5b as $C_2$, and a television signal input to the base of the transistor 5b as e''. Then, the television signal e'' is expressed by equation (2) below:

$$e'' = \frac{-e}{(\omega^2 L C_1 - 1)(1 + j\omega C_2 R) + \omega^2 L C_2} \qquad (2)$$

Since equation (2) includes an imaginary part, the television signal e'' input to the transistor 5b is not exactly in opposite phase with the television signal e output from the interstage tuning circuit 3. However, these signals have substantially opposite phases when $\omega C_2 R$ is chosen to be sufficiently smaller than 1. Actually, R is on the order of 30 to 70 $\Omega$, and $C_2$ is on the order of 2 pF. Thus, $\omega C_2 R$ is smaller than 1. Furthermore, in this case, it is required that ($\omega^2 L C_1$ - 1) be greater than 0.

Calculating the absolute value E'' of the television signal e'' according to equation (2) yields equation (3). Furthermore, letting $\omega_0$ in equation (3) be defined as expressed in equation (4), the absolute value E '' can be rewritten as expressed in equation (5).

$$E'' = \frac{e}{\sqrt{\left\{\omega^2 L (C_1 + C_2) - 1\right\}^2 + \left\{\omega C_2 R (\omega^2 L C_1 - 1)\right\}^2}} \qquad (3)$$

$$\omega_0^2 = \frac{1}{L(C_1 + C_2)} \qquad (4)$$

$$E'' = \frac{e}{\sqrt{\left\{\left(\frac{\omega}{\omega_0}\right)^2 - 1\right\}^2 + \left\{\omega C_2 R (\omega^2 L C_1 - 1)\right\}^2}} \qquad (5)$$

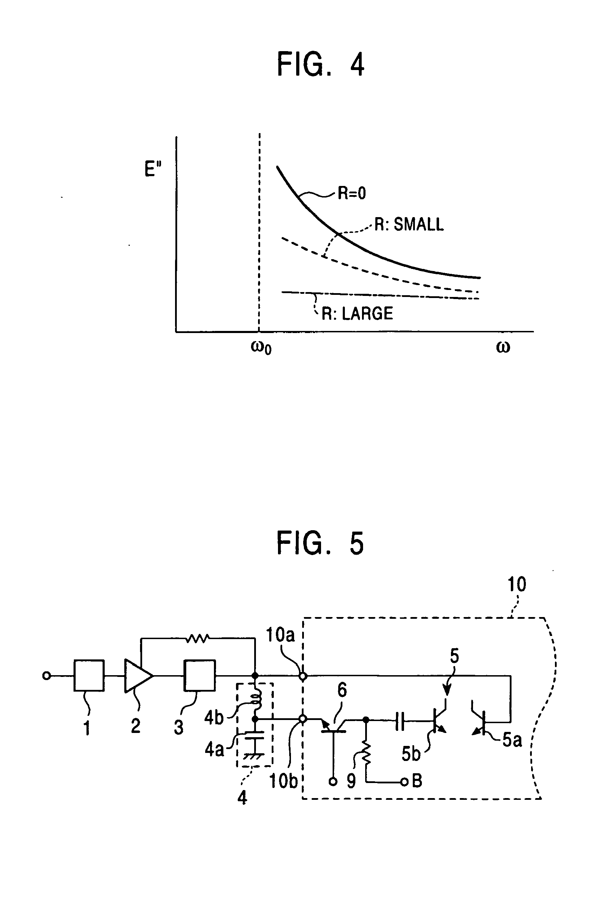

According to equation (5), if the resistance R of the resisting device 6 were zero, the absolute value E'' rapidly increases as $\omega$ approaches $\omega_0$. Actually, however, the presence of the resisting device 6 alleviates the increase in the absolute value E''. Thus, the conversion gain of the mixer circuit 5 does not substantially increase even when the frequency becomes lower. Therefore, the gain variation of the tuner is small. Fig. 4 schematically shows the variation in the absolute value E'' in relation to the resistance of the resisting device 6. An appropriate value for the actual resistance of the resisting device 6 is on the order of 30 to 70 $\Omega$.

Fig. 5 shows a specific configuration according to a second embodiment of the present invention. In this embodiment, an NPN (or PNP) switching transistor is used as the resisting device 6. The emitter of the switching transistor is connected to the second terminal 10b, and the collector of the switching transistor is coupled to the base of the transistor 5b in the mixer circuit 5. The collector of the switching transistor receives a power-supply voltage via a feed resistor 9. The switching transistor is turned on or off according to a switching signal input to the base thereof.

In order to supply power to the radio-frequency amplifier 2, a power-supply terminal of the radio-frequency amplifier 2 is DC-connected to the second terminal 10b. Thus, when the switching transistor is turned on, power is supplied to the radio-frequency amplifier 2 via the emitter of the switching transistor. Since the saturated resistance of the switching transistor that has been turned on is several tens ohm, the switching transistor functions as the resisting device 6. That is, when a television signal in the UHF band is to be received, the switching transistor is turned on, whereby the radio-frequency amplifier 2 is activated, and balanced television signals are input to the mixer circuit 5 due to the saturated resistance of the switching transistor. When a television signal in the UHF band is not to be received, for example, when a television signal in the VHF band is to be received by a VHF tuner unit that is not shown, the switching transistor is turned off, whereby input of a television signal to the mixer circuit 5 is stopped.

When the switching transistor is implemented by a PNP transistor, the collector thereof is connected to the second terminal 10b, the emitter thereof is coupled to the base of the transistor 5b of the mixer circuit 5, and the emitter thereof receives a power-supply voltage.

## Claims

1.   A television tuner comprising:

a tuning circuit (3) for tuning to a television signal in a desired channel among channels within a predetermined band;
a balanced mixer circuit (5) for converting the television signal into an intermediate-frequency signal; and
a balun circuit (4) disposed between the tuning circuit (3) and the mixer circuit (5);
wherein the balun circuit (4) includes a capacitor (4a) and an inductor (4b), the capacitor (4a) having one end grounded, and the inductor (4b) being connected in series with the capacitor (4a) and having one end coupled to a first input terminal (10a) of the mixer circuit (5), and wherein an unbalanced television signal output from the tuning circuit (3) is input to the first input terminal (10a) **characterized in that** a television signal that appears at a node between the inductor (4b) and the capacitor (4a) is input to a second input terminal (10b) of the mixer circuit (5) via resisting means (6), so that the variation in gain of the tuner (3) with respect to the frequency caused by the balun circuit (4) is reduced to thereby achieve a flat gain over the entire reception band.

2.   A television tuner according to Claim 1, wherein the mixer circuit (5) is implemented by an integrated circuit, and the resisting means (6) is formed within the integrated circuit.

3.   A television tuner according to Claim 1 or 2, wherein a radio-frequency amplifier (2) for amplifying the television signal is provided before the tuning circuit (3), and wherein the resisting means (6) is activated when power is supplied to the radio-frequency amplifier (2) to allow operation of the radio-frequency amplifier (2).

4.   A television tuner according to claim 3, wherein the resisting means (6) is implemented by a switching transistor, one of the collector and the emitter of the switching transistor being connected to the second input terminal (10b) of the mixer circuit (5) and the other of the collector and the emitter being DC-connected to a power-supply terminal of the radio-frequency amplifier (2), and wherein a power-supply voltage is applied to one of the collector and the emitter of the switching transistor to turn the switching transistor on or off.

5.   A television tuner according to Claim 4, wherein the integrated circuit has a first terminal coupled to the first input terminal (10a) of the mixer circuit (5) and a second terminal coupled to the second input terminal (10b) of the mixer circuit (5), wherein the one end of the inductor (4b) is connected to the first terminal and the node between the inductor (4b) and the capacitor (4a) is connected to the second terminal, and wherein the power-supply terminal of the radio-frequency amplifier (2) is DC-connected to the second terminal.

## Patentansprüche

1.   Fernsehtuner, aufweisend:

eine Abstimmschaltung (3) zur Abstimmung auf ein Fernsehsignal in einem erwünschten Kanal unter Kanälen innerhalb eines vorherbestimmten Bandes;

eine symmetrische Mischerschaltung (5) für die Umwandlung des Fernsehsignals in ein Zwischenfrequenzsignal; und

eine Symmetrierschaltung (4), die zwischen der Abstimmschaltung (3) und der Mischerschaltung (5) angeordnet ist;

wobei die Symmetrierschaltung (4) einen Kondensator (4a) und eine Spule (4b) umfasst, ein Ende des Kondensators (4a) masseverbunden ist und die Spule (4b) mit dem Kondensator (4a) in Serie geschaltet ist und eines seiner Enden mit einem ersten Eingangsanschluss (10a) der Mischerschaltung (5) verbunden ist und wobei eine Ausgabe eines unsymmetrischen Fernsehsignals von der Abstimmschaltung (3) dem ersten Eingangsanschluss (10a) zugeführt wird, **dadurch gekennzeichnet, dass** ein Fernsehsignal, das an einem Knotenpunkt zwischen der Spule (4b) und dem Kondensator (4a) erscheint, über eine Widerstandseinrichtung (6) einem zweiten Eingangsanschluss (10b) der Mischerschaltung (5) zugeführt wird, so dass die Verstärkungsveränderung des Tuners (3) bezüglich der von der Symmetrierschaltung (4) bewirkten Frequenz reduziert wird, um dabei eine flache Verstärkung über das gesamte Empfangsband zu erreichen.

2. Fernsehtuner nach Anspruch 1, wobei die Mischerschaltung (5) durch eine integrierte Schaltung realisiert ist und die Widerstandseinrichtung (6) innerhalb der integrierten Schaltung gebildet ist.

3. Fernsehtuner nach Anspruch 1 oder 2, wobei ein Hochfrequenzverstärker (2) zur Verstärkung des Fernsehsignals vor der Abstimmschaltung (3) vorgesehen ist und wobei die Widerstandseinrichtung (6) aktiviert wird, wenn dem Hochfrequenzverstärker (2) Energie zugeführt wird, um den Betrieb des Hochfrequenzverstärkers (2) zu erlauben.

4. Fernsehtuner nach Anspruch 3, wobei die Widerstandseinrichtung (6) durch einen Schalttransistor realisiert ist, einer von dem Kollektor und dem Emitter des Schalttransistors mit dem zweiten Eingangsanschluss (10b) der Mischerschaltung (5) verbunden ist und der andere von dem Kollektor und dem Emitter gleichstrommäßig mit einem Energieversorgungsanschluss des Hochfrequenzverstärkers (2) verbunden ist und wobei eine Energieversorgungsspannung an einen von dem Kollektor und dem Emitter des Schalttransistors angelegt wird, um den Schalttransistor ein- oder auszuschalten.

5. Fernsehtuner nach Anspruch 4, wobei die integrierte Schaltung einen ersten Anschluss hat, der mit dem ersten Eingangsanschluss (10a) der Mischerschaltung (5) gekoppelt ist, und einen zweiten Anschluss, der mit dem zweiten Eingangsanschluss (10b) der Mischerschaltung (5) gekoppelt ist, wobei das eine Ende der Spule (4b) mit dem ersten Anschluss verbunden ist und der Knotenpunkt zwischen der Spule (4b) und dem Kondensator (4a) mit dem zweiten Anschluss verbunden ist und wobei der Energieversorgungsanschluss des Hochfrequenzverstärkers (2) gleichstrommäßig mit dem zweiten Anschluss verbunden ist.

**Revendications**

1. Syntoniseur de téléviseur comprenant :

un circuit d'accord (3) pour effectuer l'accord sur un signal de télévision dans un canal voulu parmi des canaux à l'intérieur d'une bande prédéterminée ;

un circuit mélangeur équilibré (5) pour convertir le signal de télévision en un signal de fréquence intermédiaire ; et

un circuit symétriseur (4) disposé entre le circuit d'accord (3) et le circuit mélangeur (5);

dans lequel le circuit symétriseur (4) comprend un condensateur (4a) et une inductance (4b), le condensateur (4a) ayant une extrémité à la masse, et l'inductance (4b) étant montée en série avec le condensateur (4a) et ayant une extrémité couplée à une première borne d'entrée (10a) du circuit mélangeur (5), et dans lequel un signal de télévision non équilibré délivré par le circuit d'accord (3) est transmis à la première borne d'entrée (10a), **caractérisé en ce qu'**un signal de télévision qui apparaît en un noeud situé entre l'inductance (4b) et le condensateur (4a) est transmis à une deuxième borne d'entrée (10b) du circuit mélangeur (5) via un moyen résistif (6), de sorte que la variation de gain du syntoniseur (3) par rapport à la fréquence provoquée par le circuit symétriseur (4) est réduite pour obtenir ainsi un gain uniforme sur toute la bande de réception.

2. Syntoniseur de téléviseur selon la revendication 1, dans lequel le circuit mélangeur (5) est mis en oeuvre dans un circuit intégré, et le moyen résistif (6) est formé à l'intérieur du circuit intégré.

**3.** Syntoniseur de téléviseur selon la revendication 1 ou 2, dans lequel un amplificateur haute fréquence (2) pour amplifier le signal de télévision est placé avant le circuit d'accord (3), et dans lequel le moyen résistif (6) est activé lorsque l'amplificateur haute fréquence (2) est alimenté pour permettre le fonctionnement de l'amplificateur haute fréquence (2).

**4.** Syntoniseur de téléviseur selon la revendication 3, dans lequel le moyen résistif (6) est mis en oeuvre par un transistor de commutation, un élément parmi le collecteur et l'émetteur du transistor de commutation étant connecté à la deuxième borne d'entrée (10b) du circuit mélangeur (5) et l'autre de ces éléments étant connecté en direct à une borne d'alimentation de l'amplificateur haute fréquence (2), et dans lequel une tension d'alimentation est appliquée à un élément parmi le collecteur et l'émetteur du transistor de commutation pour rendre passant ou bloqué le transistor de commutation.

**5.** Syntoniseur de téléviseur selon la revendication 4, dans lequel le circuit intégré a une première borne couplée à la première bane d'entrée (10a) du circuit mélangeur (5) et une deuxième bane couplée à la deuxième borne d'entrée (10b) du circuit mélangeur (5), dans lequel la première extrémité de l'inductance (4b) est connectée à la première bane et le noeud situé entre l'inductance (4b) et le condensateur (4a) est connecté à la deuxième borne, et dans lequel la borne d'alimentation de l'amplificateur haute fréquence (2) est connectée en direct à la deuxième borne.

FIG. 1

FIG. 2

FIG. 3

# FIG. 4

# FIG. 5

# FIG. 6
## PRIOR ART

31  32  33  34  35  35a  37
34b
34a
e
e'
35b
36

# FIG. 7
## PRIOR ART

$G$

$\omega_0$  $\omega$